(19) Europäisches Patentamt / European Patent Office / Office européen des brevets

(11) **EP 4 382 938 B1**

(12) **EUROPEAN PATENT SPECIFICATION**

(45) Date of publication and mention
of the grant of the patent:
**31.12.2025 Bulletin 2026/01**

(21) Application number: **22893150.7**

(22) Date of filing: **08.11.2022**

(51) International Patent Classification (IPC):
**G01R 31/389** (2019.01)    **G01R 31/367** (2019.01)
**G01R 31/3842** (2019.01)    **G01R 19/10** (2006.01)
**G01R 19/00** (2006.01)    **G01R 31/396** (2019.01)
**G01R 31/392** (2019.01)

(52) Cooperative Patent Classification (CPC):
**G01R 31/396; G01R 31/367; G01R 31/389;**
G01R 31/392

(86) International application number:
**PCT/KR2022/017453**

(87) International publication number:
**WO 2023/085730 (19.05.2023 Gazette 2023/20)**

(54) **METHOD FOR ESTIMATING RESISTANCE OF BATTERY AND BATTERY SYSTEM FOR PROVIDING THE METHOD**

VERFAHREN ZUR SCHÄTZUNG DES DCIR EINER BATTERIE UND BATTERIESYSTEM DAMIT

PROCÉDÉ D'ESTIMATION DE DCIR DE BATTERIE ET SYSTÈME DE BATTERIE LE METTANT EN ?UVRE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **12.11.2021 KR 20210155537**

(43) Date of publication of application:
**12.06.2024 Bulletin 2024/24**

(73) Proprietor: **LG Energy Solution, Ltd.**
**Seoul 07335 (KR)**

(72) Inventor: **LEE, Cheol Soo**
**Daejeon 34122 (KR)**

(74) Representative: **Plasseraud IP**
**104 Rue de Richelieu**
**CS92104**
**75080 Paris Cedex 02 (FR)**

(56) References cited:
**CN-A- 109 802 189**    **JP-A- 2013 096 785**
**JP-A- 2014 240 807**    **JP-A- 2021 044 145**
**KR-A- 20130 057 520**    **KR-A- 20190 009 367**
**US-A1- 2014 015 537**    **US-A1- 2020 086 761**

- **HAN-SIK BAN ET AL: "Load sharing improvement in parallel-operated lead acid batteries", INDUSTRIAL ELECTRONICS, 2001. PROCEEDINGS. ISIE 2001. IEEE INTERNATIONAL SYMPOSIUM ON JUNE 12-16, 2001, PISCATAWAY, NJ, USA,IEEE, PISCATAWAY, NJ, USA, vol. 2, 12 June 2001 (2001-06-12), pages 1026 - 1031, XP010548605, ISBN: 978-0-7803-7090-6**

**Description**

**[Technical Field]**

The present invention relates to a method for estimating a resistance of a battery and a battery system for providing the method.

**[Background Art]**

Batteries that may be repeatedly charged and discharged have come into prominence as an alternative to fossil energy. Batteries have been mainly used in traditional handheld devices, such as mobile phones, video cameras, and power tools. However, in recent years, application fields of batteries tend to gradually expand to electric vehicles (EV, HEV, PHEV) that are driven by electricity, large-capacity energy storage systems (ESS), and uninterruptible power supply systems (UPS).

In the case of a battery, when capacity decreases, resistance may increase, thereby increasing electrical energy lost as heat. Therefore, when the capacity of the battery decreases below a critical value, the performance of the battery may significantly deteriorate and the amount of generated heat may increase, requiring inspection or replacement.

Meanwhile, in a battery system A including a plurality of battery packs connected in parallel, and in the case of replacing some of the plurality of battery packs having a lowered performance, a state of health (SOH) may be different between a battery pack that has already been installed and used for a predetermined period (hereinafter, referred to as an "old battery pack") and a newly mounted battery pack (hereinafter, referred to as a "new battery pack").

In this case, it is necessary to know exactly how much the old battery pack has deteriorated in order to plan an operational strategy for efficiently using the newly installed new battery pack and the old battery pack.

Further background art is described in Han-Sik Ban et al., "load sharing improvement in parallel operated lead acid batteries", 2001, Ind. Electronic 2001 Proceedings ISIE 2001, vol. 2, pp 1026-1031; US 2014/015537 A1; US 2020/086761 A1; and CN 109 802 189 A.

**[Disclosure]**

**[Technical Problem]**

The present invention provides a method for estimating a resistance of a battery for estimating a direct current internal resistance (DCIR), which is one of the factors indicating a state of health (SOH) of a battery pack, and a battery system providing the method.

**[Technical Solution]**

An example embodiment of the present invention provides a battery system including a battery including a new battery pack having a known internal resistance value and a target battery pack having an internal resistance value to be estimated, and a master battery management system (BMS) configured to estimate a target resistance value of the target battery pack based on a current value of a first compensation current flowing from the new battery pack to the target battery pack when the new battery pack and the target battery pack are connected in parallel, a new resistance value of the new battery pack, a current value of a second compensation current corresponding to a first pack voltage difference value of the new battery pack and the target battery pack, a first reference resistance value, and a second reference resistance value.

The second compensation current may be a compensation current flowing when a first reference battery pack and a second reference battery pack having a second pack voltage difference value equal to the first pack voltage difference value are connected in parallel, the first reference resistance value may be a value of an internal resistance of the first reference battery pack, and the second reference resistance value may be a value of an internal resistance of the second reference battery pack.

The battery system may further include: a memory configured to store a look-up table having mapped and recorded therein a current value of the second compensation current corresponding to each of a plurality of second pack voltage difference values including the second pack voltage difference value, and the first reference resistance value and the second reference resistance value.

The master BMS may select a second pack voltage difference value having a same voltage value as that of the first pack voltage difference value from among the plurality of second pack voltage difference values, and estimate the target resistance value of the target battery pack by extracting the current value of the second compensation current mapped to the second pack voltage difference value, the first reference resistance value, and the second reference resistance value.

The master BMS may estimate the target resistance value (Rold_t) based on the current value of the first compensation current (Im), the new resistance value (Rnew), the current value of the second compensation current (Id), the first reference resistance (Rref_1) value, and the second reference resistance (Rref_2) put into Equation (1) below:

$$Im(Rold\_t + Rnew) = Id(Rref\_1 + Rref\_2) - Equation\ (1)$$

Each of the new battery pack and the target battery pack may include: a battery module including a plurality of battery cells, a voltage sensor configured to measure a pack voltage, which is a voltage across the battery module, and a current sensor configured to measure a pack current flowing in the battery module; and a pack switch connecting the battery module to the battery system in parallel through an ON operation, and a slave BMS configured to transmit measurement results from the voltage sensor and the current sensor by communicating with the master BMS and receive a control signal for controlling a switching operation of the pack switch.

The master BMS may receive a first pack voltage value of the new battery pack and a second pack voltage value of the target battery pack measured before the new battery pack and the target battery pack are connected in parallel, and the current value of the first compensation current measured after the new battery pack and the target battery pack are connected in parallel, and calculate the first pack voltage difference value, which is a difference value between the first pack voltage value and the second pack voltage value.

Another example embodiment of the present invention provides a method for estimating a battery resistance to estimate an internal resistance value of a target battery pack in a battery system including a new battery pack having a known internal resistance value and a plurality of old battery packs having internal resistance values be estimated, including: selecting the target battery pack from among the plurality of old battery packs according to a predetermined criterion; connecting the new battery pack and the target battery pack in parallel; receiving a current value of a first compensation current flowing between the new battery pack and the target battery pack connected in parallel, a first pack voltage value of the new battery pack, and a second pack voltage value of the target battery pack; and estimating a target resistance value of the target battery pack based on a current value of the first compensation current, a new resistance value of the new battery pack, a current value of a second compensation current corresponding to a first pack voltage difference between the new battery pack and the target battery pack, a first reference resistance value, and a second reference resistance value.

The second compensation current may be a compensation current flowing when a first reference battery pack and a second reference battery pack having a second pack voltage difference value equal to the first pack voltage difference value are connected in parallel, the first reference resistance value is a value of an internal resistance of the first reference battery pack, and the second reference resistance value is a value of an internal resistance of the second reference battery pack.

The estimating of the target resistance value of the target battery pack may include: calculating the first pack voltage difference value, which is a difference value between the first pack voltage value and the second pack voltage value; and extracting the current value of the second compensation current corresponding to the second pack voltage difference value, which is a same voltage value as the first pack voltage difference value, the first reference resistance value, and the second reference resistance value, from a look-up table.

In the estimating of the target resistance value of the target battery pack, after the extracting from the lookup table, the target resistance value (Rold_t) may be estimated based on the current value of the first compensation current (Im), the new resistance value (Rnew), the current value of the second compensation current (Id), the first reference resistance (Rref_1) value, and the second reference resistance (Rref_2) put into Equation (1) below:

$$Im(Rold\_t + Rnew) = Id(Rref\_1 + Rref\_2) - Equation\ (1)$$

The receiving of the current value of the first compensation current may include receiving the first pack voltage value of the new battery pack and the second pack voltage value of the target battery pack measured before the new battery pack and the target battery pack are connected in parallel, and the current value of the first compensation current measured after the new battery pack and the target battery pack are connected in parallel.

**[Advantageous Effects]**

According to the present invention, direct current internal resistance (DCIR) of an old battery pack that is already installed in the battery system A and used for a predetermined period of time may be estimated by a simple method, without removing the old battery pack.

According to the present invention, even when there are a plurality of old battery packs, the internal resistance (DCIR) of each of the old battery packs may be estimated with high precision.

**[Description of the Drawings]**

FIG. 1 is a diagram illustrating a battery system A for estimating resistance of a battery according to an example embodiment.
FIG. 2 is a diagram specifically illustrating a configuration of a battery pack of FIG. 1.
FIGS. 3 to 5 are conceptual views illustrating a method of measuring internal resistance of an old battery pack by connecting a new battery pack and one of old battery packs, among a plurality of battery packs, in parallel.
FIG. 6 is a diagram illustrating a method of estimating a resistance of a battery according to an example embodiment.

**[Mode for Invention]**

Hereinafter, the example embodiments of the present invention will be described with reference to the accompanying drawings, in which like numbers refer to like elements throughout although the example embodiments are different, and a redundant description thereof is omitted. In the following description, usage of suffixes, such as 'module', 'part' or 'unit' used for referring to elements is given merely to facilitate explanation of the present invention, without having any significant meaning by itself. In describing the present invention, if a detailed explanation for a related known function or construction is considered to unnecessarily divert the gist of the present invention, such explanation has been omitted but would be understood by those skilled in the art. The accompanying drawings of the present invention aim to facilitate understanding of the present invention and should not be construed as limited to the accompanying drawings. Also, the present invention is not limited to a specific disclosed form, but includes all modifications, equivalents, and substitutions without departing from the scope and teaching of the present invention.

It will be understood that, although the terms first, second, etc. may be used herein to describe various elements, these elements should not be limited by these terms. These terms are only used to distinguish one element from another.

It is to be understood that when one element is referred to as being "connected to" or "coupled to" another element, it may be connected directly to or coupled directly to another element or be connected to or coupled to another element, having the other element intervening therebetween. Meanwhile, it is to be understood that when one element is referred to as being "connected directly to" or "coupled directly to" another element, it may be connected to or coupled to another element without the other element intervening therebetween.

It will be further understood that the terms "comprises" or "have" used in this specification, specify the presence of stated features, steps, operations, components, parts, or a combination thereof, but do not preclude the presence or addition of one or more other features, numerals, steps, operations, components, parts, or a combination thereof.

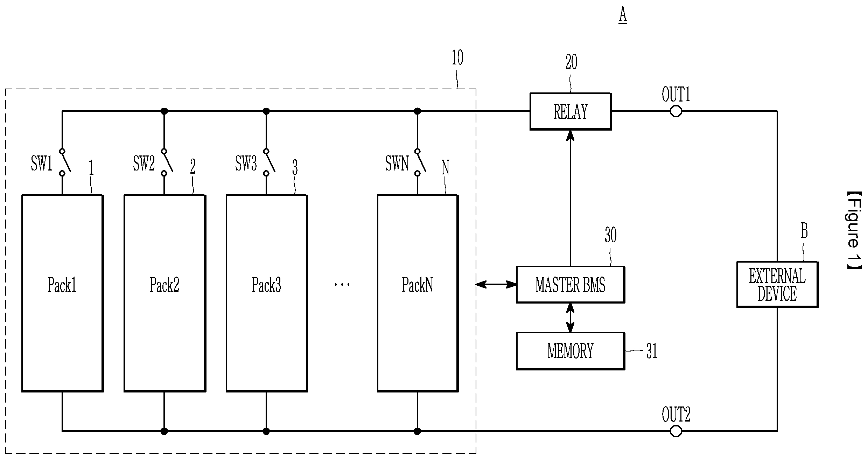

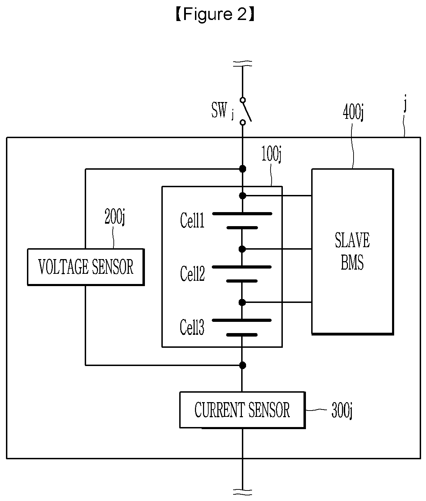

FIG. 1 is a diagram illustrating a battery system A for estimating resistance of a battery according to an example embodiment, FIG. 2 is a diagram specifically illustrating a configuration of a battery pack of FIG. 1, and FIGS. 3 to 5 are conceptual views illustrating a method of measuring internal resistance of an old battery pack by connecting a new battery pack and one of old battery packs, among a plurality of battery packs, in parallel.

Referring to FIG. 1, the battery system A includes a battery 10, a relay 20, and a master battery management system (BMS) 30.

The battery 10 includes a plurality of battery packs 1 to N (or 1-N) and a plurality of pack switches SW1 to SWN respectively connecting the plurality of battery packs 1-N to the battery system A in parallel. Hereinafter, when indicating a specific battery pack among the plurality of battery packs 1-N, reference numeral "j" is used, and a battery module, a voltage sensor, a slave BMS, and a pack switch included in the corresponding battery pack j respectively use reference numerals "j1", "j3", "j5", and "PSWj". In addition, reference numeral "SWj" is used to indicate a specific pack switch that connects a specific battery pack j, among the plurality of pack switches SW1 to SWN, to the battery system A in parallel.

Referring to FIG. 2, the battery pack j may include a battery module 100j, a voltage sensor 200j, a current sensor 300j, a slave BMS 400j, and a pack switch SWj. In FIG. 1, the battery pack j is illustrated as not including the pack switch SWj, but the present invention is not limited thereto, and the pack switch SWj corresponding to any battery pack j may be described as being included in the corresponding the battery pack j.

The battery module 100j may include a plurality of battery cells connected in series and/or in parallel. In some example embodiments, the battery cell may be a rechargeable secondary battery. In FIG. 2, a battery module 100j including three battery cells Cell1 to Cell3 connected in series is shown, but is not limited thereto. The battery module 100j may include various numbers of battery cells.

The voltage sensor 200j is connected in parallel with the battery module 100j. The voltage sensor 200j may measure a pack voltage Vj, which is a voltage across the battery module 100j, and transmit a measurement result to the master BMS 30 through the slave BMS 400j.

The current sensor 300j is connected in series with the battery module 100j. The current sensor 300j may measure a pack current Ij flowing through the battery module 100j and transmit a measurement result to the master BMS 30 through the slave BMS 400j.

The slave BMS 400j may transmit data including various information on the battery cell, the pack voltage Vj and pack current Ij (where j is 1 to N) and receive various commands through communication with the master BMS 30. For example, the slave BMS 400j may receive a control signal for controlling a switching (ON/OFF) operation of the pack switch SWj.

The relay 20 may electrically connect or disconnect the battery system (A) and the external device (B). Specifically, when the relay unit 20 electrically connects the battery system A and the external device B, the battery 10 may be charged with power from the external device B or supply power to the external device B. The external device B may be a charger in a charging mode in which the battery 10 is charged, and a load (e.g., a vehicle motor, etc.) in a discharging mode in which the battery 10 is discharged.

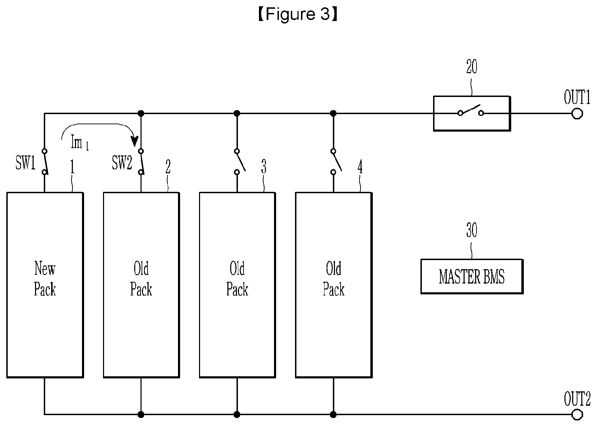

According to an example embodiment, in FIGS. 3 to 5, while the master BMS 30 estimates direct current internal resistance (DCIR) of the battery pack j, the relay 20 may be turned off. Then, the master BMS 30 may estimate the internal resistance (DCIR) of the battery pack j with high precision, without being affected by the external device B.

When the master BMS 30 communicates with an upper controller (not shown) and receives a message indicating that a new battery pack is loaded in the battery system A, the master BMS 30 may select a target battery pack whose internal resistance (DCIR) needs to be estimated, among a plurality of old battery packs.

Referring to FIG. 1, the master BMS 30 includes a memory storing a look-up table in which current values of a plurality of second compensation current respectively corresponding to a plurality of second pack voltage difference values and a reference resistance value are mapped and recorded. For example, the look-up table may be stored in the memory 31 in the form of Table 1 to be described below.

Referring to FIGS. 3 to 5, for example, it is assumed that the first battery pack 1 is a replaced new battery pack and second to fourth battery packs 2 to 4 are old battery packs. The new battery pack is an unused battery pack and may be a battery pack whose internal resistance value is known. The old battery pack may be a battery pack in which the battery system A is installed and used for a predetermined period of time, and may be a battery pack whose internal resistance value is not known.

According to an example embodiment, the master BMS 30 may select a target battery pack whose internal resistance value is to be estimated, among the second to fourth battery packs 2 to 4 that are a plurality of old battery packs, according to a predetermined criterion. The master BMS 30 may turn on each pack switch SWj so that the target battery pack and the new battery pack are connected in parallel. The master BMS 30 may estimate internal resistance (DCIR) of the target battery pack based on the pack voltage Vj of each of the target battery pack and the new battery pack and the current value of the compensation current Im flowing between the target battery pack and the new battery pack connected in parallel. Details thereof will be described below with reference to FIGS. 3 to 6.

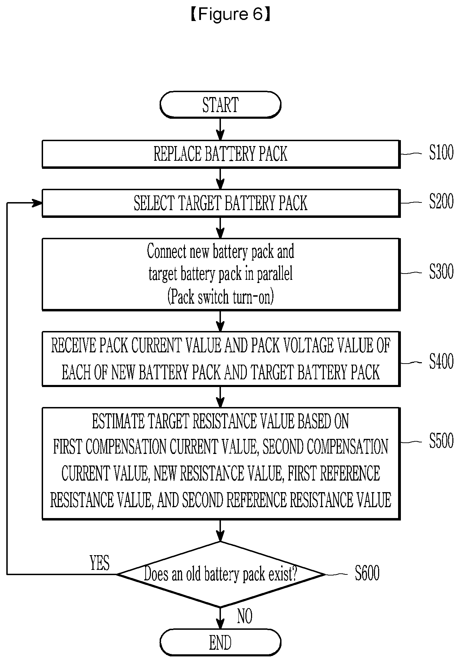

FIG. 6 is a diagram illustrating a method of estimating resistance of a battery according to an example embodiment.

Hereinafter, a method for estimating battery resistance and a battery system for providing the method will be described with reference to FIGS. 1 to 6.

Referring to FIG. 6, first, when the master BMS 30 communicates with an upper controller (not shown) and receives a message instructing that a new battery pack is loaded in the battery system A, the master BSM 30 performs an internal resistance (DCIR) estimation logic on the old battery pack (S100).

For the following description, referring to FIGS. 3 to 5, it is assumed that the first battery pack 1 is a replaced new battery pack and the second to fourth battery packs 2 to 4 are old battery packs. However, the present invention is not limited thereto, and the battery 10 may include various numbers of old battery packs and new battery packs.

Next, the master BMS 30 selects a target battery pack from among the plurality of old battery packs 2 to 4 according to a predetermined criterion (S200).

For example, when the internal resistance (DCIR) value of each of the second to fourth battery packs 2 to 4 is required, the master BMS 30 may select a target battery pack in the order of the second battery pack 2, the third battery pack 3, and the fourth battery pack 4. However, the present invention is not limited thereto, and the master BMS 30 may apply various criteria, such as randomly selecting the second to fourth battery packs 2 to 4 as target battery packs.

Next, the master BMS 30 connects the new battery pack 1 and the target battery pack j in parallel (S300).

For example, referring to FIG. 3, the master BMS 30 connect the first battery pack 1 and the second battery pack 2 in parallel by turning on the first pack switch SW1 of the first battery pack 1 that is a new battery and the second pack switch SW2 of the second battery pack 2 that is a target battery pack.

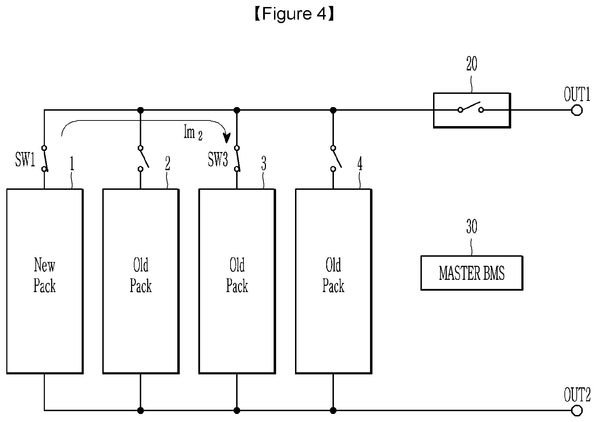

For another example, when the estimation of the internal resistance (DCIR) of the second battery pack 2 is completed (step S500 to be described below), a next target battery pack, the third battery pack 3, and a new battery, the first battery pack 1, may be connected in parallel. Referring to FIG. 4, the master BMS 30 may connect the first battery pack 1 and the third battery pack 3 in parallel by turning on the first pack switch SW1 and the third pack switch SW3.

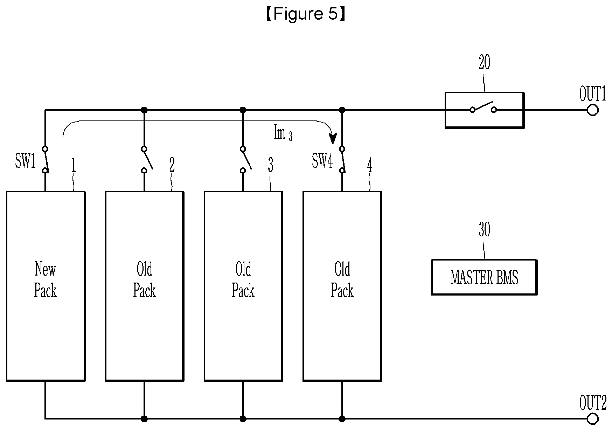

For another example, when the estimation of the internal resistance (DCIR) of the third battery pack 3 is completed (step S500 to be described below), the fourth battery pack 4 as the next target battery pack and the first battery 1 as the new battery pack may be connected in parallel. Referring to FIG. 5, the master BMS 30 may connect the first battery pack 1 and the fourth battery pack 4 in parallel by turning on the first pack switch SW1 and the fourth pack switch SW4.

Next, the master BMS 30 receives a pack current value and a pack voltage value from each of the new battery pack and the target battery pack (S400).

Referring to FIG. 3, the master BMS 30 receives a first pack current I1 value and a first pack voltage V1 value from the first battery pack 1. In addition, the master BMS 30 receives the second pack current I2 value and the second pack voltage V2 value from the second battery pack 2. At this time, the first pack current I1 is a first compensation current Im flowing between the first battery pack 1 and the second battery pack 2 connected in parallel. Also, the second pack current I2 is the first compensation current Im flowing between the first battery pack 1 and the second battery pack 2 connected in parallel. That is, when the first compensation current Im is measured in the first battery pack 1, the first compensation current Im may be the first pack current I1, and when the first pack current I1 is measured in the second battery pack 2, the first pack current I1 may be the second pack current I2.

Also, the first pack voltage V1 and the second pack voltage V2 may be pack voltages measured before the first battery pack 1 and the second battery pack 2 are connected in parallel. When the first battery pack 1 and the second battery pack 2 are connected in parallel, the first compensation current Im flows due to a first pack voltage difference $\Delta Vs$. Then, due to the self-balancing effect, the voltage values of the respective pack voltages of the first battery pack 1 and the second battery pack 2 may be the same.

Next, the master BMS 30 estimates a resistance value of the target resistance (Rold_t), which is the internal resistance (DCIR) of the target battery pack, based on the current value of the first compensation current Im, the current value of the second compensation current Idiff, the resistance value of the new resistor Rnew, the resistance value of the first reference resistor Rref_1, and the resistance value of the second reference resistance Rref_2 (S500).

A compensation current is a current generated by a voltage difference between battery packs, and is a current flowing to match voltage values between battery packs connected in parallel. According to an example embodiment, the first compensation current Im is a compensation current flowing between a new battery pack and a target battery pack connected in parallel. The second compensation current Idiff is a compensation current flowing between the first and second reference battery packs having a second pack voltage difference value $\Delta Vd$ that is the same voltage value as the first pack voltage difference value $\Delta Vs$ between the new battery pack and the target battery pack.

In operation S500, first, the master BMS 30 calculates the first pack voltage difference value ($\Delta Vs=|V1-V2|$). For example, in FIG. 3, the master BMS 30 may calculate the first pack voltage difference value $\Delta Vs$ that is a difference value between the first pack voltage V1 of the first battery pack 1 and the second pack voltage V2 of the second battery pack 2. At this time, it is assumed that the first pack voltage difference value $\Delta Vs$ is 20V.

In step S500, the master BMS 30 may extract the current value (e.g., 5A) of the second compensation current Idiff corresponding to the second pack voltage difference value ($\Delta Vd = 20V$), which is the same voltage value as the first pack voltage difference value ($\Delta Vs = 20V$), the resistance value ($2\Omega$) of the first reference resistance Rref_1, and the resistance value ($2\Omega$) of the second reference resistance Rref_2 from the look-up table.

The first pack voltage difference value $\Delta Vs$ may be a difference value between pack voltages of the new battery pack and the target battery pack. The second pack voltage difference $\Delta Vd$ may be a difference value between pack voltages of the first standard battery pack and the second standard battery pack.

Table 1 below shows the look-up table in which the current value of the second compensation current Idiff, corresponding to the difference value $\Delta Vd$ of the second pack voltage, the resistance values of the first reference resistor Rref_1, and the second reference resistor Rref_2 are mapped and recorded.

(Table 1)

| Second pack voltage difference value ($\Delta Vd$) | Second compensation current (Idiff) | First reference resistance (Rref_1) | Second reference resistance (Rref_2) |
|---|---|---|---|
| 1V | $1_a$ | $R_{a1}$ | $R_{a2}$ |
| 2V | $1_b$ | $R_{b1}$ | $R_{b2}$ |
| 3V | $1_c$ | $R_{c1}$ | $R_{c2}$ |
| ... | ... | ... | ... |
| 20V | 5A | $2\ \Omega$ | $2\ \Omega$ |
| ... | ... | ... | ... |

In step S500, the master BMS 30 may calculate or estimate the resistance value of the target resistance (Rold_t) by putting the current value of the first compensation current Im, the current value of the second compensation current Idiff, the resistance value of the new resistor Rnew, the resistance value of the first reference resistor Rref_1, and the resistance value of the second reference resistance Rref_2 into Equation (1) below:

$$Im(Rold\_t + Rnew) = Id(Rref\_1 + Rref\_2) \text{ - Equation (1)}$$

Specifically, Equation (1) may be derived on the premise that Equation (2) and Equation (3) are the same. That is, Equation (2) below is an equation for the first pack voltage difference value ($\Delta$Vs = 20V), and Equation (3) below is an equation for the second pack voltage difference value ($\Delta$Vd = 20V).

$$\Delta Vs = Im \times (Rold\_t + Rnew) \text{ - Equation (2)}$$

In Equation (2), the first pack voltage difference $\Delta$Vs represents the product of the first compensation current Im and the combined internal resistance Rold_t + Rnew of the battery packs connected in parallel. In this case, the current value of the first compensation current Im may be a current value measured in the battery pack, and the resistance value of the new resistor Rnew may be a known resistance value.

$$\Delta Vd = Id(Rref\_1 + Rref\_2) \text{ - Equation (3)}$$

In Equation (3), the second pack voltage difference value $\Delta$Vd represents the product of the second compensation current Idiff and the combined internal resistance (Rref_1 + Rref_2) of the battery packs connected in parallel. At this time, the current value of the second compensation current (Id), the resistance value of the first reference resistor Rref_1, and the resistance value of the second reference resistor Rref_2 are values that may be known through the look-up table.

In addition, in the above equation, when the performance of the new battery pack, the first reference battery pack, and the second reference battery pack are the same, and it is an unused new battery pack, the internal resistance (DCIR) value of each battery pack may be the same. In this case, Equation (1) above may be expressed as E equation (4) below.

For example, it is assumed that the current value of the first compensation current Im is 2A, the current value of the second compensation current Idiff is 5A, and a resistance value of each of the new resistance Rnew, the first reference resistance Rref_1, and the second reference resistance Rref_2 is 2$\Omega$. Then, the master BMS 30 may estimate the resistance value of the target resistance Rold_t as 8 $\Omega$.

Next, the master BMS 30 determines whether there is an old battery pack whose internal resistance value needs to be estimated (S600).

Next, when there is an old battery pack for which estimation of an internal resistance value is required, as a result of the determination (S600, Yes), the process repeats again from S200 described above. For example, when the second battery pack 2 is selected as the target battery pack and the estimation of the resistance value of the internal resistance (DCIR) of the second battery pack 2 is completed, the master BMS 30 may select the third battery pack 3 as a target battery pack. In addition, when the estimation of the resistance value of the internal resistance (DCIR) of the third battery pack 3 is completed, the master BMS 30 may select the fourth battery pack 4 as a target battery pack.

Next, when there is no old battery pack for which estimation of an internal resistance value is required, as a result of the determination (S600, No), the master BMS 30 terminates the estimation logic of the internal resistance value.

The example embodiments of the present invention have been described in detail. However, the scope of the present invention is not limited thereto and it will be apparent to those skilled in the art that modifications and variations may be made without departing from the teaching and scope of the invention.

**Claims**

1. A battery system (A) comprising:

   a battery (10) including a new battery pack (1) having a known internal resistance value and a target battery pack having an internal resistance value to be estimated, and
   a master battery management system, BMS, (30) configured to estimate a target resistance value (Rold_t) of the target battery pack based on:

      a current value (Im) of a first compensation current flowing from the new battery pack to the target battery pack when the new battery pack and the target battery pack are connected in parallel,

a new resistance value (Rnew) of the new battery pack,
a current value (Id) of a second compensation current corresponding to a first pack voltage difference value of the new battery pack and the target battery pack,
a first reference resistance value (Rref_1), and
a second reference resistance value (Rref_2).

2. The battery system of claim 1, wherein:

the second compensation current is a compensation current flowing when a first reference battery pack and a second reference battery pack having a second pack voltage difference value equal to the first pack voltage difference value are connected in parallel,
the first reference resistance value is a value of an internal resistance of the first reference battery pack, and
the second reference resistance value is a value of an internal resistance of the second reference battery pack.

3. The battery system of claim 2, further comprising:
a memory (31) configured to store a look-up table having mapped and recorded therein:

a current value of the second compensation current corresponding to each of a plurality of second pack voltage difference values including the second pack voltage difference value, and
the first reference resistance value and the second reference resistance value.

4. The battery system of claim 3, wherein:

the master BMS is configured to
select a second pack voltage difference value having a same voltage value as that of the first pack voltage difference value from among the plurality of second pack voltage difference values, and
estimate the target resistance value of the target battery pack by extracting the current value of the second compensation current mapped to the second pack voltage difference value, the first reference resistance value, and the second reference resistance value.

5. The battery system of claim 2, wherein:

the master BMS is configure to
estimate the target resistance value (Rold_t) based on the current value of the first compensation current (Im), the new resistance value (Rnew), the current value of the second compensation current (Id), the first reference resistance (Rref_1) value, and the second reference resistance (Rref_2) put into Equation (1) below:

$$Im(Rold\_t + Rnew) = Id(Rref\_1 + Rref\_2) - Equation\ (1)$$

6. The battery system of claim 1, wherein:
each of the new battery pack and the target battery pack includes:

a battery module (100j) including a plurality of battery cells (Cell1, Cell2, Cell3), a voltage sensor (200j) configured to measure a pack voltage, which is a voltage across the battery module, and a current sensor (300j) configured to measure a pack current flowing in the battery module; and
a pack switch ($SW_j$) connecting the battery module to the battery system in parallel through an ON operation, and a slave BMS (400j) configured to transmit measurement results from the voltage sensor and the current sensor by communicating with the master BMS and receive a control signal for controlling a switching operation of the pack switch.

7. The battery system of claim 6, wherein:

the master BMS is configured to
receive a first pack voltage value of the new battery pack and a second pack voltage value of the target battery pack measured before the new battery pack and the target battery pack are connected in parallel, and the current value of the first compensation current measured after the new battery pack and the target battery pack are connected in parallel, and

calculate the first pack voltage difference value, which is a difference value between the first pack voltage value and the second pack voltage value.

8. A method for estimating a battery resistance to estimate an internal resistance value of a target battery pack in a battery system including a new battery pack having a known internal resistance value and a plurality of old battery packs having internal resistance values to be estimated, the method comprising:

selecting (S200) the target battery pack from among the plurality of old battery packs according to a predetermined criterion;
connecting (S300) the new battery pack and the target battery pack in parallel;
receiving (S400) a current value of a first compensation current flowing between the new battery pack and the target battery pack connected in parallel, a first pack voltage value of the new battery pack, and a second pack voltage value of the target battery pack; and
estimating (S500) a target resistance value of the target battery pack based on:

a current value of the first compensation current,
a new resistance value of the new battery pack,
a current value of a second compensation current corresponding to a first pack voltage difference value between the new battery pack and the target battery pack,
a first reference resistance value, and
a second reference resistance value.

9. The method of claim 8, wherein:

the second compensation current is a compensation current flowing when a first reference battery pack and a second reference battery pack having a second pack voltage difference value equal to the first pack voltage difference value are connected in parallel,
the first reference resistance value is a value of an internal resistance of the first reference battery pack, and
the second reference resistance value is a value an internal resistance of the second reference battery pack.

10. The method of claim 9, wherein:
the estimating of the target resistance value of the target battery pack includes:

calculating the first pack voltage difference value, which is a difference value between the first pack voltage value and the second pack voltage value; and
extracting the current value of the second compensation current corresponding to the second pack voltage difference value, which is a same voltage value as the first pack voltage difference value, the first reference resistance value, and the second reference resistance value, from a look-up table.

11. The method of claim 10, wherein:

in the estimating of the target resistance value of the target battery pack,
after the extracting from the lookup table,
the target resistance value (Rold_t) is estimated based on the current value of the first compensation current (Im), the new resistance value (Rnew), the current value of the second compensation current (Id), the first reference resistance (Rref_1) value, and the second reference resistance (Rref_2) put into Equation (1) below:

$$Im(Rold\_t + Rnew) = Id(Rref\_1 + Rref\_2) - \text{Equation (1)}.$$

12. The method of claim 8, wherein:
the receiving of the current value of the first compensation current includes:
receiving the first pack voltage value of the new battery pack and the second pack voltage value of the target battery pack measured before the new battery pack and the target battery pack are connected in parallel, and the current value of the first compensation current measured after the new battery pack and the target battery pack are connected in parallel.

**Patentansprüche**

1.  Batteriesystem (A), umfassend:

    eine Batterie (10), welche einen neuen Batteriepack (1), welcher einen bekannten Innenwiderstandswert aufweist, und einen Zielbatteriepack umfasst, welcher einen zu schätzenden Innenwiderstandswert aufweist, und
    ein Master-Batteriemanagementsystem, BMS, (30), welches dazu eingerichtet ist, einen Zielwiderstandswert (Rold_t) des Zielbatteriepacks zu schätzen, auf Grundlage:

    eines Stromwerts (Im) eines ersten Kompensationsstroms, welcher von dem neuen Batteriepack zu dem Zielbatteriepack fließt, wenn der neue Batteriepack und der Zielbatteriepack parallel geschaltet sind,
    eines neuen Widerstandswerts (Rnew) des neuen Batteriepacks,
    eines Stromwerts (Id) eines zweiten Kompensationsstroms, welcher einem ersten Packspannungsdifferenzwert des neuen Batteriepacks und des Zielbatteriepacks entspricht,
    eines ersten Referenzwiderstandswerts (Rref_1) und
    eines zweiten Referenzwiderstandswerts (Rref_2).

2.  Batteriesystem nach Anspruch 1, wobei:

    der zweite Kompensationsstrom ein Kompensationsstrom ist, welcher fließt, wenn ein erster Referenzbatteriepack und ein zweiter Referenzbatteriepack, welcher einen zweiten Packspannungsdifferenzwert aufweist, der gleich dem ersten Packspannungsdifferenzwert ist, parallel geschaltet sind,
    der erste Referenzwiderstandswert ein Wert eines Innenwiderstands des ersten Referenzbatteriepacks ist und
    der zweite Referenzwiderstandswert ein Wert eines Innenwiderstands des zweiten Referenzbatteriepacks ist.

3.  Batteriesystem nach Anspruch 2, ferner umfassend:
    einen Speicher (31), welcher dazu eingerichtet ist, eine Nachschlagtabelle zu speichern, welche darin abgebildet und aufgezeichnet aufweist:

    einen Stromwert des zweiten Kompensationsstroms, welcher jedem einer Mehrzahl von zweiten Packspannungsdifferenzwerten entspricht, welche den zweiten Packspannungsdifferenzwert umfassen, und
    den ersten Referenzwiderstandswert und den zweiten Referenzwiderstandswert.

4.  Batteriesystem nach Anspruch 3, wobei:
    das Master-BMS eingerichtet ist, zum:

    Auswählen eines zweiten Packspannungsdifferenzwerts, welcher einen gleichen Spannungswert wie der des ersten Packspannungsdifferenzwerts aufweist, aus der Mehrzahl von zweiten Packspannungsdifferenzwerten und
    Schätzen des Zielwiderstandswerts des Zielbatteriepacks durch ein Extrahieren des Stromwerts des zweiten Kompensationsstroms, welcher auf dem zweiten Packspannungsdifferenzwert, den ersten Referenzwiderstandswert und den zweiten Referenzwiderstandswert abgebildet ist.

5.  Batteriesystem nach Anspruch 2, wobei:
    das Master-BMS eingerichtet ist, zum:
    Schätzen des Zielwiderstandswerts (Rold_t) auf Grundlage des Stromwerts des ersten Kompensationsstroms (Im), des neuen Widerstandswerts (Rnew), des Stromwerts des zweiten Kompensationsstroms (Id), des ersten Referenzwiderstands-(Rref_1)-Werts und des zweiten Referenzwiderstands (Rref_2), eingesetzt in nachstehende Gleichung (1):

    $$Im(Rold\_t + Rnew) = Id(Rref\_1 + Rref\_2) - \text{Gleichung (1)}$$

6.  Batteriesystem nach Anspruch 1, wobei:
    jeder des neuen Batteriepacks und des Zielbatteriepacks umfasst:

    ein Batteriemodul (100j), welches eine Mehrzahl von Batteriezellen (Cell1, Cell2, Cell3), einen Spannungssensor (200j), welcher dazu eingerichtet ist, eine Packspannung zu messen, welche eine Spannung über das Batteriemodul ist, und einen Stromsensor (300j) umfasst, welcher dazu eingerichtet ist, einen Packstrom zu messen, welcher in dem Batteriemodul fließt; und

einen Packschalter (SW$_j$), welcher das Batteriemodul durch einen EIN-Betrieb parallel zu dem Batteriesystem schaltet, und ein Slave-BMS (400j), welches dazu eingerichtet ist, Messergebnisse von dem Spannungssensor und dem Stromsensor durch ein Kommunizieren mit dem Master-BMS zu übertragen und ein Steuersignal zum Steuern eines Schaltbetriebs des Packschalters zu empfangen.

7. Batteriesystem nach Anspruch 6, wobei:
   das Master-BMS eingerichtet ist, zum:

   Empfangen eines ersten Packspannungswerts des neuen Batteriepacks und eines zweiten Packspannungswerts des Zielbatteriepacks, welcher gemessen wird, bevor der neue Batteriepack und der Zielbatteriepack parallel geschaltet werden, und des Stromwerts des ersten Kompensationsstroms, welcher gemessen wird, nachdem der neue Batteriepack und der Zielbatteriepack parallel geschaltet worden sind, und
   Berechnen des ersten Packspannungsdifferenzwerts, welcher ein Differenzwert zwischen dem ersten Packspannungswert und dem zweiten Packspannungswert ist.

8. Verfahren zum Schätzen eines Batteriewiderstands, um einen Innenwiderstandswert eines Zielbatteriepacks in einem Batteriesystem zu schätzen, welches einen neuen Batteriepack, welcher einen bekannten Innenwiderstandswert aufweist, und eine Mehrzahl von alten Batteriepacks umfasst, welche zu schätzende Innenwiderstandswerte aufweisen, wobei das Verfahren umfasst:

   Auswählen (S200) des Zielbatteriepacks aus der Mehrzahl von alten Batteriepacks gemäß einem vorbestimmten Kriterium;
   parallel Schalten (S300) des neuen Batteriepacks und des Zielbatteriepacks;
   Empfangen (S400) eines Stromwerts eines ersten Kompensationsstroms, welcher zwischen dem neuen Batteriepack und dem Zielbatteriepack fließt, welche parallel geschaltet sind, eines ersten Packspannungswerts des neuen Batteriepacks und eines zweiten Packspannungswerts des Zielbatteriepacks; und
   Schätzen (S500) eines Zielwiderstandswerts des Zielbatteriepacks, auf Grundlage:

   eines Stromwerts des ersten Kompensationsstroms,
   eines neuen Widerstandswerts des neuen Batteriepacks,
   eines Stromwerts eines zweiten Kompensationsstroms, welcher einem ersten Packspannungsdifferenzwert des neuen Batteriepacks und des Zielbatteriepacks entspricht,
   eines ersten Referenzwiderstandswerts und
   eines zweiten Referenzwiderstandswerts.

9. Verfahren nach Anspruch 8, wobei:

   der zweite Kompensationsstrom ein Kompensationsstrom ist, welcher fließt, wenn ein erster Referenzbatteriepack und ein zweiter Referenzbatteriepack, welcher einen zweiten Packspannungsdifferenzwert aufweist, der gleich dem ersten Packspannungsdifferenzwert ist, parallel geschaltet sind,
   der erste Referenzwiderstandswert ein Wert eines Innenwiderstands des ersten Referenzbatteriepacks ist und
   der zweite Referenzwiderstandswert ein Wert eines Innenwiderstands des zweiten Referenzbatteriepacks ist.

10. Verfahren nach Anspruch 9, wobei:
    das Schätzen des Zielwiderstandswerts des Zielbatteriepacks umfasst:

    Berechnen des ersten Packspannungsdifferenzwerts, welcher ein Differenzwert zwischen dem ersten Packspannungswert und dem zweiten Packspannungswert ist; und
    Extrahieren des Stromwerts des zweiten Kompensationsstroms, welcher dem zweiten Packspannungsdifferenzwert entspricht, der ein gleicher Spannungswert wie der des ersten Packspannungsreferenzwerts ist, des ersten Referenzwiderstandswerts und des zweiten Referenzwiderstandswerts aus einer Nachschlagtabelle.

11. Verfahren nach Anspruch 10, wobei:

    bei dem Schätzen des Zielwiderstandswerts des Zielbatteriepacks nach dem Extrahieren aus der Nachschlagtabelle

der Zielwiderstandswert (Rold_t) geschätzt wird, auf Grundlage des Stromwerts des ersten Kompensationsstroms (Im), des neuen Widerstandswerts (Rnew), des Stromwerts des zweiten Kompensationsstroms (Id), des ersten Referenzwiderstands-(Rref_1) -Werts und des zweiten Referenzwiderstands (Rref_2), eingesetzt in nachstehende Gleichung (1):

$$Im(Rold\_t + Rnew) = Id(Rref\_1 + Rref\_2) - \text{Gleichung (1)}.$$

**12.** Verfahren nach Anspruch 8, wobei:
das Empfangen des Stromwerts des ersten Kompensationsstroms umfasst:
Empfangen des ersten Packspannungswerts des neuen Batteriepacks und des zweiten Packspannungswerts des Zielbatteriepacks, welcher gemessen wird, bevor der neue Batteriepack und der Zielbatteriepack parallel geschaltet werden, und des Stromwerts des ersten Kompensationsstroms, welcher gemessen wird, nachdem der neue Batteriepack und der Zielbatteriepack parallel geschaltet worden sind.

**Revendications**

**1.** Système de batterie (A) comprenant :

une batterie (10) comportant un nouveau bloc-batterie (1) ayant une valeur de résistance interne connue et un bloc-batterie cible ayant une valeur de résistance interne à estimer, et
un système de gestion de batterie, BMS, (30) maître configuré pour estimer une valeur de résistance cible (Rold_t) du bloc-batterie cible sur la base :

d'une valeur de courant (Im) d'un premier courant de compensation circulant du nouveau bloc-batterie vers le bloc-batterie cible lorsque le nouveau bloc-batterie et le bloc-batterie cible sont connectés en parallèle,
d'une nouvelle valeur de résistance (Rnew) du nouveau bloc-batterie,
d'une valeur de courant (Id) d'un second courant de compensation correspondant à une première valeur de différence de tension de bloc du nouveau bloc-batterie et du bloc-batterie cible,
d'une première valeur de résistance de référence (Rref_1), et
d'une seconde valeur de résistance de référence (Rref_2).

**2.** Système de batterie selon la revendication 1, dans lequel :

le second courant de compensation est un courant de compensation circulant lorsqu'un premier bloc-batterie de référence et un second bloc-batterie de référence ayant une seconde valeur de différence de tension de bloc égale à la première valeur de différence de tension de bloc sont connectés en parallèle,
la première valeur de résistance de référence est une valeur d'une résistance interne du premier bloc-batterie de référence, et
la seconde valeur de résistance de référence est une valeur d'une résistance interne du second bloc-batterie de référence.

**3.** Système de batterie selon la revendication 2, comprenant en outre :
une mémoire (31) configurée pour stocker une table de consultation dans laquelle sont mappées et enregistrées :

une valeur de courant du second courant de compensation correspondant à chacune d'une pluralité de secondes valeurs de différence de tension de bloc, comportant la seconde valeur de différence de tension de bloc, et
la première valeur de résistance de référence et la seconde valeur de résistance de référence.

**4.** Système de batterie selon la revendication 3, dans lequel :

le BMS maître est configuré pour
sélectionner une seconde valeur de différence de tension de bloc ayant une même valeur de tension que celle de la première valeur de différence de tension de bloc parmi la pluralité de secondes valeurs de différence de tension de bloc, et
estimer la valeur de résistance cible du bloc-batterie cible en extrayant la valeur de courant du second courant de compensation mappée sur la seconde valeur de différence de tension de bloc, la première valeur de résistance de référence, et la seconde valeur de résistance de référence.

5. Système de batterie selon la revendication 2, dans lequel :

le BMS maître est configuré pour
estimer la valeur de résistance cible (Rold_t) en fonction de la valeur de courant du premier courant de compensation (Im), de la nouvelle valeur de résistance (Rnew), de la valeur de courant du second courant de compensation (Id), de la première valeur de résistance de référence (Rref_1) et de la seconde résistance de référence (Rref_2) placées dans l'Équation (1) ci-dessous :

$$Im(Rold\_t + Rnew) = Id(Rref\_1 + Rref\_2) - \text{Équation (1)}$$

6. Système de batterie selon la revendication 1, dans lequel :
chacun des nouveau bloc-batterie et bloc-batterie cible comporte :

un module de batterie (100j) comportant une pluralité de cellules de batterie (Cell1, Cell2, Cell3), un capteur de tension (200j) configuré pour mesurer une tension de bloc, qui est une tension aux bornes du module de batterie, et un capteur de courant (300j) configuré pour mesurer un courant de bloc circulant dans le module de batterie ; et un commutateur de bloc (SW$_j$) connectant le module de batterie au système de batterie en parallèle par une opération de mise à l'état passant (ON), et un BMS esclave (400j) configuré pour transmettre des résultats de mesure provenant du capteur de tension et du capteur de courant en communiquant avec le BMS maître et pour recevoir un signal de commande afin de commander une opération de commutation du commutateur de bloc.

7. Système de batterie selon la revendication 6, dans lequel :

le BMS maître est configuré pour
recevoir une première valeur de tension de bloc du nouveau bloc-batterie et une seconde valeur de tension de bloc du bloc-batterie cible mesurées avant que le nouveau bloc-batterie et le bloc-batterie cible ne soient connectés en parallèle, et la valeur de courant du premier courant de compensation mesurée après que le nouveau bloc-batterie et le bloc-batterie cible ont été connectés en parallèle, et calculer la première valeur de différence de tension de bloc, qui est une valeur de différence entre la première valeur de tension de bloc et la seconde valeur de tension de bloc.

8. Procédé d'estimation d'une résistance de batterie pour estimer une valeur de résistance interne d'un bloc-batterie cible dans un système de batterie comportant un nouveau bloc-batterie ayant une valeur de résistance interne connue et une pluralité de blocs-batteries usagés ayant des valeurs de résistance interne à estimer, le procédé comprenant :

la sélection (S200) du bloc-batterie cible parmi la pluralité de blocs-batteries usagés selon un critère prédéterminé ;
la connexion (S300) du nouveau bloc-batterie et du bloc-batterie cible en parallèle ;
la réception (S400) d'une valeur de courant d'un premier courant de compensation circulant entre le nouveau bloc-batterie et le bloc-batterie cible connectés en parallèle, d'une première valeur de tension de bloc du nouveau bloc-batterie, et d'une seconde valeur de tension de bloc du bloc-batterie cible ; et l'estimation (S500) d'une valeur de résistance cible du bloc-batterie cible sur la base : d'une valeur de courant du premier courant de compensation,
d'une nouvelle valeur de résistance du nouveau bloc-batterie,
d'une valeur de courant d'un second courant de compensation correspondant à une première valeur de différence de tension de bloc entre le nouveau bloc-batterie et le bloc-batterie cible,
d'une première valeur de résistance de référence, et
d'une seconde valeur de résistance de référence.

9. Procédé selon la revendication 8, dans lequel :

le second courant de compensation est un courant de compensation qui circule lorsqu'un premier bloc-batterie de référence et un second bloc-batterie de référence, ayant une seconde valeur de différence de tension de bloc égale à la première valeur de différence de tension de bloc, sont connectés en parallèle,

la première valeur de résistance de référence est une valeur d'une résistance interne du premier bloc-batterie de référence, et

la seconde valeur de résistance de référence est une valeur de résistance interne du second bloc-batterie de référence.

**10.** Procédé selon la revendication 9, dans lequel :
l'estimation de la valeur de résistance cible du bloc-batterie cible comporte :

le calcul de la première valeur de différence de tension de bloc, qui est une valeur de différence entre la première valeur de tension de bloc et la seconde valeur de tension de bloc ; et

l'extraction de la valeur de courant du second courant de compensation correspondant à la seconde valeur de différence de tension de bloc, qui est une même valeur de tension que la première valeur de différence de tension de bloc, à la première valeur de résistance de référence, et à la seconde valeur de résistance de référence, à partir d'une table de consultation.

**11.** Procédé selon la revendication 10, dans lequel :

lors de l'estimation de la valeur de résistance cible du bloc-batterie cible,

après l'extraction à partir de la table de consultation,

la valeur de résistance cible (Rold_t) est estimée en fonction de la valeur de courant du premier courant de compensation (Im), de la nouvelle valeur de résistance (Rnew), de la valeur de courant du second courant de compensation (Id), de la première valeur de résistance de référence (Rref_1), et de la seconde résistance de référence (Rref_2) placées dans l'Équation (1) ci-dessous :

$$Im(Rold\_t + Rnew) = Id(Rref\_1 + Rref\_2) \text{ - Équation (1)}.$$

**12.** Procédé selon la revendication 8, dans lequel :
la réception de la valeur de courant du premier courant de compensation comporte :
la réception de la première valeur de tension de bloc du nouveau bloc-batterie et de la seconde valeur de tension de bloc du bloc-batterie cible mesurées avant que le nouveau bloc-batterie et le bloc-batterie cible ne soient connectés en parallèle, et de la valeur de courant du premier courant de compensation mesurée après que le nouveau bloc-batterie et le bloc-batterie cible ont été connectés en parallèle.

【Figure 1】

【Figure 2】

【Figure 3】

【Figure 4】

【Figure 5】

【Figure 6】

```
                    ┌──────────────┐
                    │    START     │
                    └──────┬───────┘
                           ▼
        ┌──────────────────────────────────────┐
        │        REPLACE BATTERY PACK           │─── S100
        └──────────────────┬───────────────────┘
                           ▼
   ┌──▶┌──────────────────────────────────────┐
   │   │      SELECT TARGET BATTERY PACK       │─── S200
   │   └──────────────────┬───────────────────┘
   │                      ▼
   │   ┌──────────────────────────────────────┐
   │   │       Connect new battery pack and    │
   │   │     target battery pack in parallel   │─── S300
   │   │        (Pack switch turn-on)          │
   │   └──────────────────┬───────────────────┘
   │                      ▼
   │   ┌──────────────────────────────────────┐
   │   │ RECEIVE PACK CURRENT VALUE AND PACK   │
   │   │ VOLTAGE VALUE OF EACH OF NEW BATTERY  │─── S400
   │   │ PACK AND TARGET BATTERY PACK          │
   │   └──────────────────┬───────────────────┘
   │                      ▼
   │   ┌──────────────────────────────────────┐
   │   │     ESTIMATE TARGET RESISTANCE VALUE  │
   │   │ BASED ON FIRST COMPENSATION CURRENT   │
   │   │ VALUE, SECOND COMPENSATION CURRENT    │─── S500
   │   │ VALUE, NEW RESISTANCE VALUE, FIRST    │
   │   │ REFERENCE RESISTANCE VALUE, AND       │
   │   │ SECOND REFERENCE RESISTANCE VALUE     │
   │   └──────────────────┬───────────────────┘
   │                      ▼
   │  YES        ◇────────────────◇
   └───────────◇ Does an old battery  ◇─── S600
              ◇    pack exist?       ◇
               ◇────────┬───────────◇
                        │ NO
                        ▼
                 ┌──────────────┐
                 │     END      │
                 └──────────────┘
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2014015537 A1
- US 2020086761 A1

- CN 109802189 A

**Non-patent literature cited in the description**

- **HAN-SIK BAN et al.** load sharing improvement in parallel operated lead acid batteries. *Ind. Electronic 2001 Proceedings ISIE 2001*, 2001, vol. 2, 1026-1031